# EUROPEAN PATENT APPLICATION

(11) **EP 1 610 371 A1**
(43) Date of publication of application: **28.12.2005**
(21) Application number: 04425459.7
(22) Date of filing: 24.06.2004
(51) Int. Cl.: H01L 21/331, H01L 21/265

(54) **SiGe heterojunction bipolar transistors**

(71) Applicant: STMicroelectronics S.r.l., 20041 Agrate Brianza (Milano) (IT)
(72) Inventor: Ward, Peter John, Peterborough UK PE8 5QJ (GB); Letterio, Fiore, 98122 Messina (IT)
(74) Representative: Botti, Mario

(57) **Abstract**

The invention relates to a method for reducing both Base Boron out-diffusion and End-Of-Range (EOR) damages in a process for manufacturing SiGe heterostructures with Germanium implantation for forming the base region of a SiGe semiconductor device, wherein, when the base window has been opened on a semiconductor substrate ready for:
- the Base Boron implant; and
- the Germanium implant of appropriate dose and energy,

A Fluorine implant of an appropriate dose and energy is added to the process such that there is a sequential implant of the three elements Ge, F and B, in any order.

The addition of an appropriate Fluorine implant to the sequence reduces Boron diffusion at all stages of HBT manufacture hence reducing the Base width of the transistor and improving its performance. It also eliminates the Ge induced damage to the Silicon lattice close to the Collector-Base junction reducing its impact on junction leakage.

This sequence of Germanium Fluorine and Boron implantation may also be applied to the manufacture of MOS transistors.

## Description

### Field of the Invention

The present invention generally relates to a method for reducing Base Boron diffusion and End-Of-Range (EOR) damages in a process for manufacturing SiGe heterostructures with Germanium implantation.

The process is used, particularly but not exclusively, for the manufacturing of heterojunction devices, such as heterojunction bipolar transistors (HBT) and high speed bipolar transistors, detectors and high speed diodes.

More specifically the invention relates to a method for reducing base boron diffusion and end-of-range damage evolution in Silicon or Silicon Germanium compound semiconductor in a process for manufacturing SiGe heterostructure devices, wherein at least a base window is opened on a semiconductor substrate for forming the base region of a SiGe semiconductor device.

In this respect, it is well known in the art of manufacturing SiGe Heterojunction Bipolar Transistor that the Base doping requires a precise control of dopant diffusion.

Boron-implant impurity profile does not follow a strict Gaussian distribution due to scattering effects during implantation due to the lighter mass of the dopant and to the natural Silicon interstitial population which mediates the Boron diffusion.

The long tail formed by excessive channeling of Boron atoms in the Silicon/ Silicon Germanium lattice causes wider Base width, which in turn leads to a drastic degradation of transistor parameters, for example gain-bandwidth product, dc gain and Early voltage.

Furthermore, it is also well known in the art that, when manufacturing a SiGe hetreojunction by means of Ge implantation, the correct optimisation of the Germanium profile in terms of DC and RF performances generates the EOR damage in an area very close to the Collector-Base junction of the transistor, which in turn has the possibility of producing leakage within said junction, negatively affecting the device performances.

Without any limitation of the scope of the invention and with the only aim of simplifying its disclosure, the following description is given with reference to the process steps for manufacturing an NPN heterostructure bipolar transistor (HBT) for high speed/ high frequency device applications. In these high speed Bipolar transistor an appropriate Germanium implant is added to the Base formation sequence to provide the potential for an ideal Gaussian implanted Base profile and a heterojunction at the Collector-Base junction to increase the common emitter current gain of the HBT and to decrease the minority carrier transit time across the Base.

In fact the method of the invention can be applied in those cases where Silicon interstitials, naturally present in the film or structure, or introduced by implant need to be reduced or compensated. An example of this would be the Source and Drain regions of a small dimension p-channel MOS transistor.

In particular it can be applied in those cases where other solutions to limit the diffusion of Boron, for instance epitaxial SiGe deposition processes in which Boron diffusion is limited by incorporating Carbon that is a common deleterious contaminant in Silicon, fail or become unfeasible, not suitable, or unreliable.

### Prior Art

As is well known to those skilled in the semiconductor field, the addition of Germanium to Silicon technologies to form Silicon/ Silicon Germanium (SiGe) devices allows the manufacture of high-performance heterojunction bipolar transistors (HBTs) for very high frequency applications.

HBTs can operate at much higher speeds than standard silicon bipolar transistor, because in the Base, the layers of Silicon to which Germanium has been added exhibit a smaller band-gap if compared to a layer including only Silicon.

In the case where this is applied to the Emitter-Base junction the band-gap for the base is lower than the band-gap of the emitter, this difference in band-gap creates an energy barrier which improves the emitter injection frequency and therefore the gain of the transistor.

Moreover the lower band-gap of the base allows the base to be heavily doped, for instance with Boron, both maintaining the current gain and lowering the resistance of the base to achieve faster operation speeds.

In the case where the heterojunction is applied to the Collector-Base junction the reduction in band-gap produces an electric field across the Base which aids minority carrier diffusion and hence reduces the minority carrier transit time.

Heterojunctions can be formed at either or both junctions of the transistor depending on the precise characteristics required.

Therefore SiGe heterostructure technology applied to bipolar transistor devices improves:
- the injection efficiency of the charge carriers;
- the maximum oscillation frequency, which characterizes the power transfer in and out of the bipolar device; and
- the cut-off frequency of the device that is a function of the base transit time.

Any process for manufacturing a high speed Bipolar transistors can be modified to produce heterojunction devices by adding an appropriate Germanium implant to the Base formation sequence.

In SiGe technologies in general a large amount of Germanium is added to Silicon to form a compound semiconductor. SiGe alloy and heterostructures can be deposited by different methods, for instance by means of molecular beam epitaxy (MBE) or chemical vapour deposition (CVD).

The process steps to manufacture such heterostructures are well known from the prior art and the literature, and reference is made to the books by: S. Wolf and R.N. Tauber, "Silicon Processing for the VLSI Era", Lattice Press, Vol. 2, pg. 506-510 and P Ashburn "SiGe Heterojunction Bipolar Transistors", John Wiley & Sons, Chapter 7.

As known and described for instance in the US patent No. 6,624,017 and in the article by: S. Lombardo, C. Spinella, S.U. Campisano, A. Pinto, P. Ward in "Nuclear Instruments & Methods", Section B, 1 Jan. 1999, vol. 147, nr. 1-4, pg. 56-61, other methods can be conveniently adopted to prepare SiGe heterostructure, such as ion implantation, which has the advantage of shorter process steps than the previous techniques, yielding a fair quality within more acceptable times, especially for large volume production lines.

One of the issues that emerges from the process steps of creating the SiGe structure by means of Ge ion implantation into Silicon layers, relates to the End Of Range (EOR) damage generated by the Germanium implant.

On the one side the optimization of implantation profiles of the Germanium (Ge) atomic species allows for spatial modulation of the energy gap between the Base region and the collector region of the transistor; on the other side the correct optimization of the Ge profile from the point of view of DC and RF performance results in the EOR damage being very close to the Collector-Base junction of the transistor.

One of the factors driving to the formation of Ge EOR damage is the precipitation of Silicon interstitials which are in part naturally present in the Silicon layer but are mostly introduced by the Ge implant itself.

In the manufacture of a NPN SiGe heterojunction bipolar transistor (HBTs) another major challenge is the realization of thin and highly doped Base layers, which allow high performances of the devices, because such Base doping requires a precise control of dopant diffusion.

Both in the Base formation process itself and in later process steps inherent in the formation of an HBT structure, for instance during thermal cycling or thermal treatments, one of the issues to be addressed is the Boron out-diffusion from the Base.

Even small amount of Boron out-diffusion from a heavily doped SiGe base into the Si emitter and collector cause parasitic barrier in the conduction band, which can drastically reduce the collector current performances of the transistor. Moreover Base Boron out-diffusion has the effect of widening the Base width thus extending the implanted basewidth well beyond the intended result and therefore causing degradation of transistor performances.

The effect of out-diffusion of Boron from the SiGe layer is well known from the prior art and the literature, reference is still made to the article by: B. Heinemann, D. Knoll, G. Fischer, D. Krueger, G. Lippert, H.J. Osten, H. Ruecker, W. Roepke, P. Schley, B. Tillack, "Control of steep Boron profiles in Si/SiGe heterojunction bipolar transistors"; and to the article by: B. S. Meyerson, "Silicon:germanium-based mixed-signal technology for optimization of wired and wireless telecommunications".

One of the causes of Boron diffusion is again the presence of a natural Silicon interstitial population, because Boron diffusion is mediated by Silicon interstitials.

A solution that is well known to those skilled in the semiconductor field, and that is mainly used in epitaxial SiGe, is to incorporate Carbon into the epitaxial deposition process, i.e. to grow SiGeC, which acts to suppress Boron diffusion, as reported in the literaure for instance in the article by: L. D. Lanzerotti, A. St. Amour, C. W. Liu, J. C. Sturm, J. K. Watanabe, D. Theodore, "Si/Si_{1-*X*}Ge_{*X*}/C_{*Y*} Heterojunction Bipolar Transistors," *IEEE Electron Device Lett.* 17, 334 (1996). The complexity of this solution is illustrated by K Oda, E Ohue, I Suzumura, R Hayami, A Kodama, H Shimamoto, and K Washio "High-Performance Self-Aligned SiGeC HBT with Selectively Grown Si/Ge/C Base by UHV/CVD" IEEE TRANSACTIONS ON ELECTRON DEVICES, VOL. 50, NO. 11, NOVEMBER 2003, p 2213 where no less than five discrete different layers are deposited for a total thickness of 100nm.

Although this solution could be applied to the implanted version of SiGe either during the conventional epitaxial layer processing or as an implant, it is also well known that Carbon is a common deleterious contaminant in Si and is better avoided. The difficult challenges presented by the incorporation of carbon into the SiGe material system are known in the prior art and described as due, among others, to low bulk solubility of Carbon in Silicon and Germanium, to the lack of thermally stable phases of Carbon in SiGe alloy, and to Silicon Carbide (SiC) precipitation. These issues are also reported for instance in the article by: B. S. Meyerson, "Silicon:germanium-based mixed-signal technology for optimization of wired and wireless telecommunications".

The Japanese patent Nr. 6077247 and with more details the U.S. Patent Nr. 6,069,062 address the problem of retarding diffusion of dopant materials during thermal annealing in the process of forming shallow Source/Drain diffusions for CMOS applications, by implanting Fluorine into the semiconductor wafer.

In the process of forming shallow Source/Drain diffusions for CMOS applications, Fluorine implantations have been shown to patially solve a similar technical issue from the technical problems which affect Silicon-Germanium heterojunction bipolar transistor but the mechanisms and best methods have been unclear up to the point of the work which is the subject of this patent.

In fact, shallow junction formation in CMOS find their limitation in the increasing of the junction depths caused by the dopant material diffusion from the implanted region during to the annealing process that is used for activation of the implanted dopant material itself, right after the same has been introduced in the semiconductor wafer.

In this case the Fluorine implant is limited to the shallow regions of Source/ Drain diffusions, i.e. the energy for the implantation is selected to obtain shallow F implants. However, this patent reveals that a better method is to use a deep Fluorine implant which maximizes the effect of the meta-stable Silicon vacancies introduced by the Fluorine implant.

In contrast with SiGe heterostructure manufacturing processes, the effect of reducing dopant out-diffusion cannot be limited to the first anneal after implant, but shall remain and extend to all the process steps after implant.

Demanding requirements to optimize SiGe HBT potentials and to exploit SiGe HBT performances often find their limit in the capability of reducing both end-of-range damage evolution and base Boron out-diffusion, and the case of Silicon interstitials within the SiGe heterostructure region is particularly evident, as also reported by the article by: R. Raman, M. E. Law, V. Krishnamoorthy and K. S. Jones, "Effect of the End-of-Range Loop Layer Depth on the Evolution of {311} Defects," Appl. Phys. Lett, 74(5), 700-702, 1999; and the article by: L.S. Robertson, M.E. Law, K.S. Jones, L.M. Rubin, J. Jackson, P. Chi, and D.S. Simmons, "Correlation of End-of-Range Damage Evolution and Transient Enhanced Diffusion of Boron in Regrown Silicon," Appl. Phys. Lett. 75(24), 3844-3846, 1999.

From the previous prior art attempts it appears that no satisfactory solution have yet been provided to the technical problems of the Base Boron diffusion within the SiGe HBT structure and the End Of Range (EOR) damage generated by the Germanium implant, wherein both issues arise from the presence of Silicon interstitials, due partly to the natural Silicon interstitial population and partly generated by the ion implant steps.

Moreover, no solution has been provided which:
- Solves both problems in the manufacturing of SiGe heterostructures;
- Could be compatible with the limitation imposed by Carbon contamination;
- Could be compatible with the current and conventional manufacturing steps for realizing SiGe heterostructures, by epitaxy or by Germanium implant;
- Could be compatible with Boron doped ion-implanted base conventionally used in bipolar junction transistor and therefore it does not increase process complexity; and
- Could be compatible with the subsequent manufacturing steps.

Therefore in the semiconductor manufacturing field there exists a strong need for providing a method of manufacturing SiGe heterostructure devices wherein Silicon interstitials are reduced, where said interstitials may cause alterations to the SiGe heterostructure devices at all stages of HBT manufacture, and in particular at all stages where thermal treatments are involved.

In particular the aim of the present invention is that of providing a method to reduce both end-of-range damage evolution and base Boron out-diffusion, as a consequence of the presence of Silicon interstitials naturally existing in the Silicon layers or introduced by ion implant, in particular by implant of Germanium atomic species.

Another aim of the present invention is to manufacture a shallow Boron profile which does not move significantly during latter HBT's manufacturing stages.

Still another aim of the present invention is to reduce the Ge induced damage to the Silicon lattice close to the Collector-Base junction reducing its impact on junction leakage.

A further aim of the present invention is to provide a technique for very shallow Source and Drain junctions of MOS transistors by the appropriate co-implantation of Germanium and Fluorine.

### Summary of the invention

The solution idea of the present invention is that of providing a method that obviate the incompatibilities and limitations of the prior art by introducing an improved sequence where a Fluorine implant of an appropriate dose and energy is added to the process such that there is a sequential implant of the three elements Ge, F and B, in any order.

An appropriately chosen F implant injects a stable population of Silicon vacancies into the critical region of the transistor. These Silicon vacancies compensate the natural Silicon interstitial population, and those Silicon interstitials introduced by the Ge implant.

According to this solution idea the technical problem is solved by a method including at least the following steps:
- A Germanium implant of appropriate dose and energy in said base region;
- A Boron implant in said base region; and
characterized by:
- a Fluorine implant of an appropriate dose and energy at any time with respect to the above implant steps.
   The features and advantages of the method according to this invention will become apparent from the following description of an embodiment thereof, given by way of non-limitative example with reference to the accompanying drawings.

### Brief Description of the Drawings

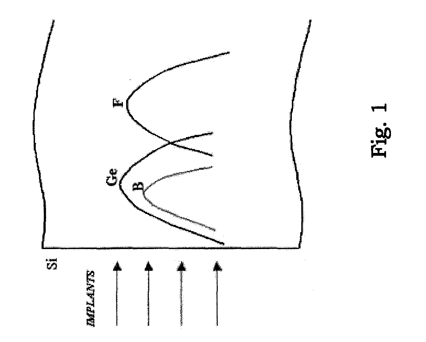

FIG.1 illustrates a diagram reporting the implant profiles of Germanium, Boron and Fluorine within the Silicon layer which represents the base region of the HBT realized with the standard process flow and with the method of the invention.

### Detailed Description

The addition of germanium to silicon technologies to form silicon germanium (SiGe) devices has created a revolution in the semiconductor industry.

In SiGe technology Germanium is added to Silicon to form a compound semiconductor.

SiGe is grown on standard Silicon substrates to manufacture high-performance heterojunction bipolar transistors (HBTs), which can operate at much higher speeds than standard silicon bipolar transistors.

Any process for the manufacture of high speed Bipolar transistors can be modified to produce heterojunction devices by adding an appropriate Germanium implant to the Base formation sequence.

Metamorphosis from a Si homojunction to a SiGe heterojunction bipolar transistor (HBT) can be made for instance by implanting Germanium atomic species or by growing an epitaxial layer of SiGe alloy on an Si wafer after full device isolation has been completed. This basic structure will be subjected to sequential processing steps according to the method of this invention.

The process steps and the structures described herein below do not form a complete process flow for manufacturing integrated circuits. In fact, this invention can be practiced jointly with integrated circuit manufacturing techniques currently used in the art, and only those common process steps will be discussed herein as are necessary to an understanding of the invention.

The preferred embodiment of the present invention will first be presented, and a discussion of the advantages of the invention will follow.

The example refers specifically to the manufacturing of a NPN heterojunction bipolar transistor in order to clarify the description and facilitate the understanding, but this shall not be intended as a limitation or restriction of the scope of the invention.

In the preferred embodiment, when a Base window has been opened ready for a Base Boron implant, a Germanium implant of appropriate dose and energy is applied before the Base Boron implant.

This invention relates to an improved sequence where a Fluorine implant of an appropriate dose and energy is added to the process such that there is a sequential implant of the three elements Ge, F and B, in any order.

Generally and preferably, within the same process flow, the F implant energy is chosen to place the F impurity deeper than the Ge in order to place the Silicon vacancy population in the most advantageous position. The Ge implant in turn is normally deeper than the B implant.

Figure 1 schematically illustrates the profile of the atom species implanted according to the inventive idea.

According to the preferred embodiment, Germanium and Fluorine are advantageously co-implanted.

After these implants, a conventional process of re-crystallization is performed followed by any subsequent process to form the remaining portions of the transistor structure.

The phenomena of Base Boron diffusion and defect generation from the Ge implant are believed to occur during these following steps, which includes but are not limited to crystal re-growth, Base dopant activation, sidewall spacer or other structural formation, Emitter deposition and Emitter diffusion.

The addition of the Fluorine atoms and, still according to the preferred embodiment, the co-implantation of Germanium and Fluorine, has the very favorable effect of solving both problems.

The action of Fluorine is not only to suppress Boron diffusion at all stages of HBT manufacture, but, a correctly chosen energy for the Fluorine implant modifies the re-crystallization of the Silicon in such a way as to remove the Ge EOR from the Collector-Base junction.

The present invention in based from a discovery that the mechanism for both the Boron diffusion suppression and the elimination of the Ge EOR damage is the same.

An appropriately chosen F implant injects a stable population of Silicon vacancies into the critical region of the transistor. These Silicon vacancies compensate the natural Silicon interstitial population, and those Silicon interstitials introduced by the Ge implant.

Since Boron diffusion is mediated by Silicon interstitials, it is reduced, and, since the mechanism for the formation of Ge EOR damage is the precipitation of Silicon interstitials, it is also reduced.

Moreover this co-implant of Ge and F results in a shallow Boron profile which does not move significantly during these latter stages. Also, if the doses and energies are appropriately chosen then implantation damage effects are much reduced in comparison with doing the implants singly.

Thus, the invention provides a method for reducing Boron diffusion at all stages of HBT manufacture hence reducing the Base width of the transistor and improving its performance. It also eliminates the Ge induced damage to the Silicon lattice close to the Collector-Base junction reducing its impact on junction leakage. In this way very shallow, low leakage SiGe HBTs can be realized.

The introduction of an appropriate Fluorine implant to the sequence of forming the base heterostructure of a bipolar transistor does not increase process complexity and does not interfere with the standard process flow and the techniques generally in use in the art and known to those skilled in the semiconductor field.

With the solution idea of the present invention there is no longer need for special Carbon addition to the SiGe heterostructure, capable of limiting Base Boron out-diffusion that in the prior art processes however is a common source of difficult challenges due to the deleterious contamination effect that incorporation of Carbon has, especially in epitaxial deposition processes.

Advantageously, the solution idea also facilitates the manufacturing process of SiGe heterostructures by means of Ge implantation, which does not interfere with the ion-implanted base conventionally used in bipolar transistor and does not require special dedicated manufacturing technologies that, as described before,
- involve lengthy processing steps;
- command strict control on physical parameters;
- are not well suited for large volume production lines; and
- could in fact introduce further costs and yield hazards.

The method of the invention has the further advantage of reducing the End-Of-Range (EOR) damage, which comes from the Germanium implant, and occurs in an area very close to the Collector-Base junction of the transistor.

## Claims

1. Method for reducing base boron diffusion and end-of-range damage evolution in Silicon or Silicon Germanium compound semiconductor in a process for manufacturing SiGe heterostructure devices, wherein at least a base window is opened on a semiconductor substrate for forming the base region of a SiGe semiconductor device, the method including at least:
- A Germanium implant of appropriate dose an energy in said base region;
- A Boron implant in said base region;
**characterized by**:
- a Fluorine implant of an appropriate dose and energy at any time with respect to the above implant steps.

2. A method according to Claim 1, **characterized in that**:
- said Fluorine implant energy is chosen to place the F impurity deeper than the Germanium species.

3. A method according to Claim 1, **characterized in that**:
- said Fluorine is co-implanted with Germanium.

4. A method according to Claim 1, **characterized in that** the SiGe heterostructure device is a SiGe Hereojunction Bipolar Transistor.

5. A method according to Claim 1, **characterized in that** the SiGe heterostructure device is a high speed bipolar transistor.

6. A method according to Claim 1, **characterized in that** the SiGe heterostructure device is a high speed diode.

7. A method according to Claim 1, **characterized in that** the SiGe heterostructure structure may be applied to MOS transitors.

8. A method according to Claim 1, **characterized in that** the SiGe heterostructure device is a high speed detector.

9. A method according to Claim 2, **characterized in that**:
- the Ge implant energy is chosen to place Ge deeper than the B implant.

10. A method according to Claim 2, **characterized in that** the SiGe heterostructure structure may be applied to MOS transitors.11. A method according to Claim 4, **characterized in that** the SiGe heterostructure device is a NPN high speed bipolar transistor.
